**Europäisches Patentamt**

**European Patent Office**

**Office européen des brevets**

(19)

(11) Publication number: **0 086 628**
**A2**

(12) ## EUROPEAN PATENT APPLICATION

(21) Application number: **83300664.6**

(22) Date of filing: **10.02.83**

(51) Int. Cl.³: **H 01 L 27/14**

(30) Priority: **16.02.82 US 349411**

(43) Date of publication of application: **24.08.83**
**Bulletin 83/34**

(84) Designated Contracting States: **DE FR GB**

(71) Applicant: **XEROX CORPORATION, Xerox Square - 020, Rochester New York 14644 (US)**

(72) Inventor: **Abd-El, Fattah A. Ibrahim, 4016 Via Picaposte, Palos Verdes, California 90274 (US)**
Inventor: **Chi, Chang, 2299 Piedmont No.622, Berkeley, California 94720 (US)**

(74) Representative: **Weatherald, Keith Baynes et al, European Patent Attorney Rank Xerox Limited Patent Department Rank Xerox House 153-157 Cleveland Street, London W1 (GB)**

(54) **Photodiode array.**

(57) A photodiode array imager (50) is described which utilizes polysilicon isolation in place of the normal field implant and field oxide isolation techniques for the purpose of reducing peripheral leakage current. A polysilicon layer 54 is utilized to isolate the sensor structure. This polysilicon layer is grown over a thin gate oxide (52) which has received a threshold enhancement implant with low value in relation to the compensation implant (16).

-1-

# PHOTODIODE ARRAY

This invention relates to a photodiode array imager which utilizes polysilicon isolation in place of the normal field implant and field oxide isolation techniques for the purpose of reducing peripheral leakage current.

The present sensor structure used in the development of charge coupled device (CCD) linear array imagers utilizes metal insulator semiconductor (MIS) for the photodiode structure. The active sensor area is isolated with a field implant and field oxide layer. The threshold voltage of the field oxide is enhanced by ion implementation of a p-layer (in the case of n-type metal oxide semiconductor) in the silicon surface before the oxidation process. Experiemental investigations found that the dark current spikes and optical non-uniformities of sensors could be caused by the stacking faults generated under the field oxide and due to the field threshold enhancement implant. For further background see "Charge Coupled Devices and Systems", edited by M.J. Hoes, et al, 1979, John Wiley and Sons Ltd., Page 96, and Electronics 30 November 81, pp 108-110, 'sensors sharpen their images; logic chips reach high voltages', by R Beresford.

Photodiode array imagers are conventionally fabricated using a field implant and field oxide isolation between the photodiode elements. Although in the past, peripheral leakage studies have been reported in the case of dynamic MOS memories, little, or no, work has been done to study and minimize similar effects in CCD imagers. Because of the increasing emphasis on high resolution electronic scanning, the photodiodes in linear imagers tend to be narrow in the horizontal scanning direction and long in the vertical scanning direction. This results in higher periphery to surface area ratio for each photodiode region. The "birds beak" effect along the periphery region contains dislocations induced by the field oxidation process, whereas the heavy field implant in the channel stop regions causes stacking faults. These "plane" defects, when activated by a surface depletion, bleed large amounts of leakage current into the photodiode storage area causing a fixed pattern noise and signal non-uniformity of the imager.

-2-

According to the present invention, a sensor structure uses polysilicon isolation to eliminate the field implant and field oxidation. A polysilicon layer is utilized to isolate the sensor structure and is incorporated with a photodiode sensor. A layer of polysilicon is incorporated between the photodiode sensors for isolation. This polysilicon (polycrystalline silicon) layer is grown over a thin gate oxide which has received a threshold enhancement implant (p-type) with low value in relation to the compensation implant.

For a more complete understanding of the invention, reference may be had to the following detailed description of the invention in conjunction with the drawings wherein:

Figure 1 is a side or cross sectional view of a prior art charge coupled device;

Figure 2 is a side or cross sectional view of a first sensor structure utilizing the present invention;

Figure 3 is a top view of a charge coupled device shown and described in conjunction with Figure 2 and;

Figure 4 is a top view of a charge coupled device utilizing a second approach in accordance with the present invention implementing a polysilicon isolated sensor structure.

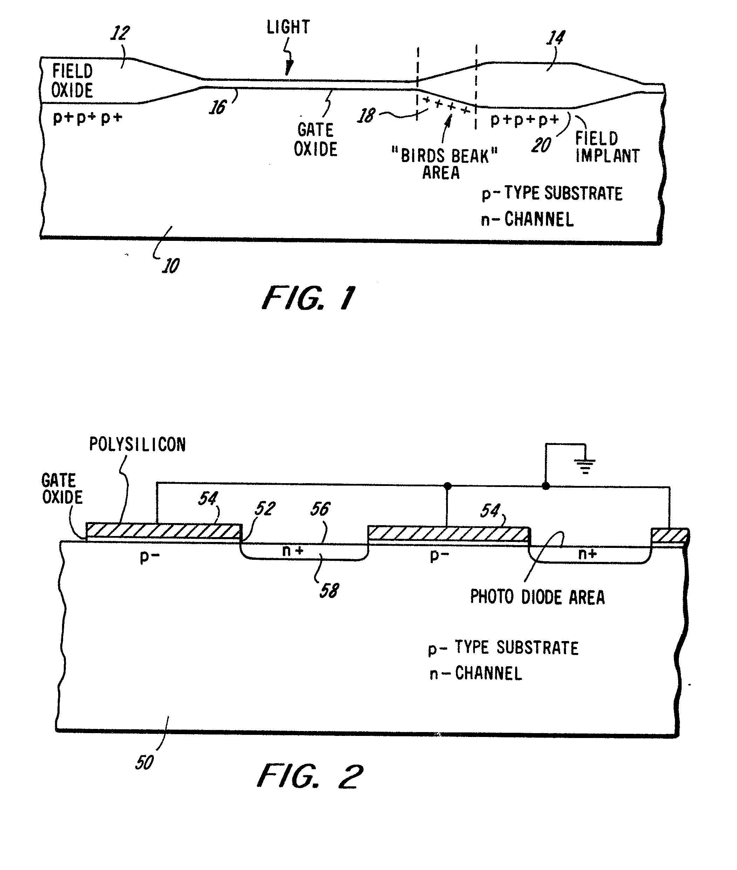

Figure 1 shows a side or cross-sectional view of a charge coupled device using prior art type techniques with field implants, field oxides, and gate oxides, etc. That is, Figure 1 shows a p-type silicon material 10 as the substrate for the charge coupled device. Field Oxide areas 12 and 14 are grown on the substrate as usual in order to isolate the photosensitive area 16 which comprises a gate oxide material. The "birds beak" region 18 of the field oxide area 14 is shown and would cause the dark current spikes believed to be caused by lattice defects in the silicon substrate, especially the oxidation-induced stacking fault. Also shown are the field implant p-type material 20 in relation to the field oxide layers.

Figure 2 of the present application shows a side view or cross sectional view of the polysilicon isolated sensor structure of the present invention. Substrate 50 would comprise the same type of p-type silicon, for an n-channel device, as substrate 10 in Figure 1. Instead of the field oxide layers and gate oxide areas, Figure 2 can be seen to comprise areas of polysilicon 54 deposited over a thin gate oxide (100 nm) area 52. The layer of gate oxide (silicon dioxide) would receive a threshold enhancement implant (p-type) with a low value, as seen by the p- in Figure 2. The photodiode area 56 of substrate 50 has been implanted with a heavy application of n-type material 58. The implant in area 52 comprises a light dose of boron which is used to shift the threshold under gates 54 to approximately 1.5 volts. This structure provides for a sensitive photodiode area 56 while eliminating the birds beak region and stacking fault effects as set forth in conjunction with Figure 1. In the normal device operation this polyisolation gate is grounded and provides the required channel isolation. This sensor structure has been successfully implemented in a 1744 element high resolution photodiode array with other features, with improved doped current non-uniformity of the imager.

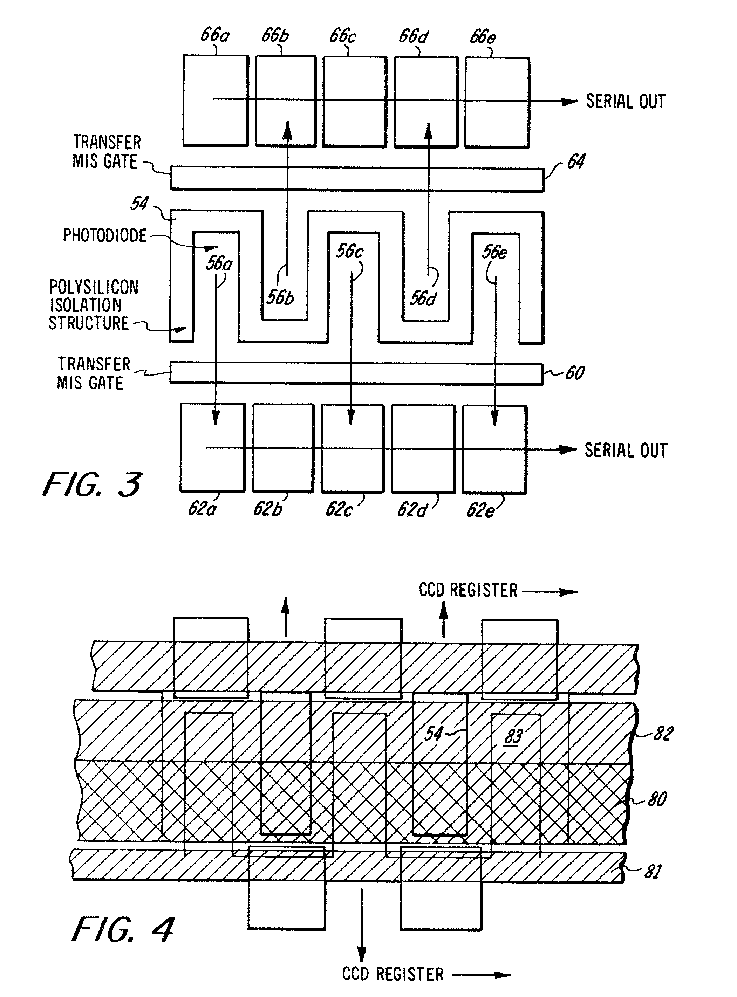

Figure 3 shows a top view of part of a polyisolation linear imager showing the sensor layout technique of a larger CCD image array. The polysilicon isolation structure 54, similar to that of designation 54 in Figure 2, is seen in Figure 3 to be in a serpentine shape. This serpentine shape isolates the photodiode areas 56a through 56e. Upon imaging of the light onto the photodiode areas, the charge stored under each photosite 56a, 56c, and 56e would be transferred via MIS transfer gate 60 to the CCD storage registers 62a through 62e. The charge stored under photosites 56b and 56d would be transferred via MIS transfer gate 64 to the CCD storage registers 66a through 66e. Once the signals are received and stored in registers 62 and 66, a separate clock is utilized to transfer the data out of the registers in serial fashion to combine either on the CCD device chip or external to the device for multiplexing of the signal onto one serial train representative of the information impinged upon photosites 56a through 56e.

Figure 4 shows a second approach in relation to the polysilicon isolated sensor structure. As can be seen in Figure 4, a second layer of polysilicon 80 over the serpentine polysilicon area 54, separated by an

-4-

insulating layer 82, only covers part of the photosensor area. The MIS (metal-insulator-semiconductor) capacitor formed in the active area is used to store the charge signal generated in the photodiode area 83. It is noted that in relation to the imager shown in Figure 3, the charge has a direct transfer of signal to the CCD registers 62 and 66; while in Figure 4, the charge is transferred through the storage polysilicon layer 80 to the CCD registers.

CLAIMS

1.      A polysilicon isolated photodiode array imager comprising:

a silicon substrate (50),

a first layer of gate oxide (52) grown in a predetermined pattern on said silicon substrate,

a second layer (54) overlying said layer of gate oxide in said predetermined pattern to define photosite areas on said substrate in the areas devoid of said first and second layers,

transfer gate means for transferring electric charge accumulated under said photosites in response to impinged light thereon, and storage register means for receiving said charge and transferring said charge out from said photosite array in a serial order.

2.      The imager as set forth in Claim 1 wherein said gate oxide (52) had received a threshold enhancement implant of a first electrical type and said defined photosite areas of said silicon substrate had received a heavy implant of a second electrical type.

3.      The imager as set forth in Claim 2 wherein said substrate is of the first electrical type, the imager operating as a second electrical type channel device.

4.      The imager as set forth in Claim 3 wherein said first electrical type is p-type, and said second electrical type is n-type, said imager being an n-channel device.

5.      The imager as set forth in Claim 1 wherein said first (52) and second (54) layers are grown on said substrate (50) in a regularly ordered serpentine shape, said serpentine shape defining said photosite areas.

6.      The imager as set forth in Claim 6 wherein said second layer comprises polycrystalline silicon.

7.        A polysilicon isolated photodiode array imager comprising:

a silicon substrate (50),

a first layer of gate oxide (52) grown in a predetermined pattern on said silicon substrate,

a second layer of polycrystalline silicon (54) overlying said layer of gate oxide on said predetermined pattern to define photosite areas on said substrate in the areas devoid of said first and second layers,

a third layer of insulating material 82 covering the entire predetermined pattern, and

a fourth layer of polycrystalline silicon 80 over part of said predetermined pattern to form capacitor means in the photodiode active area to store the electric charge generated in said photodiode areas.

8.        The imager as set forth in Claim 7 further including storage register means for receiving said electric charge stored in said capacitor means and transferring said charge out from said photosite array in a serial order.

0086628

FIG. 1

FIG. 2

FIG. 3

66a 66b 66c 66d 66e

SERIAL OUT

TRANSFER MIS GATE — 64

54

PHOTODIODE

POLYSILICON ISOLATION STRUCTURE

56a 56b 56c 56d 56e

TRANSFER MIS GATE — 60

SERIAL OUT

62a 62b 62c 62d 62e

FIG. 4

CCD REGISTER →

54 83 — 82

— 80

— 81

CCD REGISTER →